## Europäisches Patentamt
## European Patent Office
## Office européen des brevets

(11) Veröffentlichungsnummer: **0 131 146**
**B1**

(12) **EUROPÄISCHE PATENTSCHRIFT**

(45) Veröffentlichungstag der Patentschrift:
13.09.89

(51) Int. Cl.⁴: **H 03 K 17/945**

(21) Anmeldenummer: **84106332.4**

(22) Anmeldetag: **02.06.84**

(54) Elektronisches, vorzugsweise berührungslos arbeitendes Schaltgerät.

(30) Priorität: **10.06.83 DE 3320975**

(43) Veröffentlichungstag der Anmeldung:
**16.01.85 Patentblatt 85/3**

(45) Bekanntmachung des Hinweises auf die Patenterteilung:
**13.09.89 Patentblatt 89/37**

(84) Benannte Vertragsstaaten:
**AT BE CH DE FR GB IT LI LU NL SE**

(56) Entgegenhaltungen:
**EP-A-0 092 710**
**DE-A-2 808 156**
**DE-A-2 922 309**
**DE-B-2 330 233**
**DE-B-2 616 265**

(73) Patentinhaber: **i f m electronic gmbh, Teichstrasse 4, D-4300 Essen 1 (DE)**

(72) Erfinder: **Buck, Robert, Ing. Grad., Vogelherdbogen 67, D-7992 Tettnang (DE)**
Erfinder: **Czech, Ingo Sigurd, Ing. Grad., Stettiner strasse 13, D-7990 Friedrichshafen 1 (DE)**
Erfinder: **Lamarche, Jean Luc, Dipl.Ing., Zeppelinstrasse 1, D-7994 Langenargen (DE)**

(74) Vertreter: **Gesthuysen, Hans Dieter, Dipl.- Ing., Patentanwälte Gesthuysen + von Rohr Huyssenallee 15 Postfach 10 13 33, D-4300 Essen 1 (DE)**

## Beschreibung

Die Erfindung betrifft ein elektronisches Schaltgerät, das über einen Außenleiter mit einem Pol einer Spannungsquelle und nur über einen weiteren Außenleiter mit einem Anschluß eines Verbrauchers verbindbar ist, wobei der andere Anschluß des Verbrauchers an den anderen Pol der Spannungsquelle anschließbar ist, mit einem von außen beeinflußbaren Anwesenheitsindikator, mit einem von dem Anwesenheitsindikator - ggf. über einen Schaltverstärker - steuerbaren elektronischen Schalter und mit einer Hilfsschaltung zur Erzeugung einer Hilfsspannung für den Anwesenheitsindikator und ggf. den Schaltverstärker, wobei die Hilfsschaltung zur Erzeugung einer Hilfsspannung für den Anwesenheitsindikator und ggf. den Schaltverstärker ein Stromzuführungselement, ein Spannungsbegrenzungselement und einen DC/DC-Wandler aufweist bzw. wobei die Hilfsschaltung zur Erzeugung einer Hilfsspannung für den Anwesenheitsindikator und ggf. den Schaltverstärker ein Stromzuführungselement, ein Spannungsbegrenzungselement und einen DC/DC-Wandler aufweist, in Reihe zu dem elektronischen Schalter eine im wesentlichen reelle Hilfsimpedanz geschaltet ist und der Primärkreis des DC/DC-Wandlers der Hilfsimpedanz parallelgeschaltet ist.

Elektronische Schaltgeräte der zuvor beschriebenen Art sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Das gilt insbesondere für sog. Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um, d. h. bei einem als Schließer ausgeführten Schaltgerät wird der nichtleitende elektronische Schalter nunmehr leitend, während bei einem als Öffner ausgeführten Schaltgerät der leitende elektronische Schalter nunmehr sperrt.

Wesentlicher Bestandteil von elektronischen Schaltgeräten der zuvor beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein, es handelt sich dann um induktive oder kapazitive Annäherungsschalter. Als Anwesenheitsindikator kann z. B. auch ein Fotowiderstand, eine Fotodiode oder ein Fototransistor vorgesehen sein; es handelt sich dann um optoelektronische Annäherungsschalter.

Bei induktiven Annäherungsschaltern gilt für den Oszillator, solange ein Metallteil einen vorgegebenen Abstand noch nicht erreicht hat, $K \cdot V = 1$ mit $K$ = Rückkopplungsfaktor und $V$ = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors $V$, so daß $K \cdot V < 1$ wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V < 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors $K$, so daß $K \cdot V = 1$ wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen word. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Bei elektronischen Schaltgeräten, die über einen Außenleiter mit einem Pol einer Spannungsquelle und nur über einen weiteren Außenleiter mit einem Anschluß eines Verbrauchers verbindbar sind, ist die Erzeugung einer Hilfsspannung für den Anwesenheitsindikator und ggf. den Schaltverstärker nicht problemlos, weil ja sowohl im leitenden Zustand als auch im gesperrten Zustand des Schaltgerätes die Hilfsspannung erzeugt werden muß, - die einen Hilfsstrom zur Folge hat, so daß letzten Endes einem solchen Schaltgerät im leitenden Zustand und im gesperrten Zustand eine elektrische Hilfsleistung zugeführt werden muß (Hilfsleistung als Produkt aus Hilfsspannung und Hilfsstrom). Von ihrer Funktion als Schaltgeräte her soll aber bei den in Rede stehenden elektronischen Schaltgeräten im leitenden Zustand praktisch kein Spannungsabfall auftreten und im gesperrten Zustand praktisch kein Reststrom fließen. Da dann, wenn bei Schaltgeräten der in Rede stehenden Art im leitenden Zustand kein Spannungsabfall auftritt, auch keine Hilfsspannung gewonnen werden kann, und dann, wenn im gesperrten Zustand kein Reststrom fließt, auch kein Hilfsstrom gewonnen werden kann, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig, im leitenden Zustand ein Spannungsabfall auftritt und im gesperrten Zustand ein Reststrom fließt, der Spannungsabfall und der Reststrom so gering wie möglich sein sollen.

Bei dem elektronischen Schaltgerät, von dem die Erfindung konkret ausgeht (vgl. die DE-A-2 922 309), ist bereits erkannt worden, daß sich der Spannungsabfall im leitenden Zustand des Schaltgerätes weiter reduzieren läßt, wenn man die Hilfsschaltung zur Erzeugung einer Hilfsspannung für den Anwesenheitsindikator und ggf. den Schaltverstärker mit einem DC/DC-Wandler versieht, - weil mit einem solchen DC/DC-Wandler im Sekundärkreis eine höhere Wandlerspannung als im Primärkreis gewonnen werden kann, folglich der Spannungsabfall im leitenden Zustand des Schaltgerätes geringer sein kann als die benötigte Hilfsspannung für den Anwesenheitsindikator und ggf. den Schaltverstärker. Dabei wird der DC/DC-Wandler erst dann "aktiviert", wenn der elektronische Schalter, hier ein Triac, leitend geworden ist. Daß bei dem bekannten elektronischen Schaltgerät, von dem die Erfindung ausgeht, der DC/DC-Wandler erst dann "aktiviert" wird, wenn der elektronische Schalter leitend geworden ist, hat zum Inhalt, daß die erste Voraussetzung für das Arbeiten des DC/DC-Wandlers ist, daß in seinem Primärkreis ein Hilfsstrom eingespeist wird, daß die zweite Voraussetzung für das Arbeiten des DC/DC-Wandlers ist, daß er gesteuert wird, d. h. daß der Primärkreis periodisch geöffnet und wieder geschlossen wird. Bei diesem bekannten elektronischen Schaltgerät sind die beiden zuvor aufgeführten Voraussetzungen für das Arbeiten des DC/DC-Wandlers erst erfüllt, wenn der elektronische Schalter leitend geworden ist, - und zwar erst eine bestimmte Zeit, nachdem der elektronische Schalter leitend geworden ist.

Der Erfindung liegt nun die Aufgabe zugrunde, das elektronische Schaltgerät, von dem die Erfindung ausgeht, so auszugestalten und weiterzubilden, daß der DC/DC-Wandler schneller seine Funktion übernehmen kann.

Das erfindungsgemäße elektronische Schaltgerät, bei dem die zuvor aufgezeigte Aufgabe gelöst ist, ist dadurch gekennzeichnet, daß der Primärkreis des DC/DC-Wandlers dem elektronischen Schalter oder dem Brückeneingang eines dem elektronischen Schalter ggf. vorgeschalteten Brückengleichrichters parallelgeschaltet ist und der DC/DC-Wandler unmittelbar von dem Anwesenheitsindikator - ggf. über den Schaltverstärker - gesteuert wird bzw. dadurch gekennzeichnet, daß der Hilfsimpedanz ein Pufferkondensator parallelgeschaltet ist und der DC/DC-Wandler unmittelbar von dem Anwesenheitsindikator - ggf. über den Schaltverstärker - gesteuert wird. In beiden Fällen steht eine für den Hilfsstrom im Primärkreis des DC/DC-Wandlers erforderliche Spannung auch bzw. bereits dann zur Verfügung, wenn der elektronische Schalter noch nicht leitend gesteuert ist, über den elektronischen Schalter also noch kein Strom fließt. Bei der ersten Alternative ist das dadurch realisiert, daß der Primärkreis des DC/DC-Wandlers dem elektronischen Schalter oder dem Brückeneingang eines dem elektronischen Schalter ggf. vorgeschalteten Brückengleichrichters parallelgeschaltet ist. Demgegenüber ist bei der zweiten Alternative der der Hilfsimpedanz parallelgeschaltete Pufferkondensator ursächlich dafür, daß die für einen Hilfsstrom im Primärkreis des DC/DC-Wandlers erforderliche Spannung auch dann zur Verfügung steht, wenn der elektronische Schalter noch nicht leitend gesteuert ist.

Wie bereits mehrfach ausgeführt, muß bei Schaltgeräten der in Rede stehenden Art bei leitendem elektronischen Schalter dem Lastkreis die Hilfsleistung entnommen werden, die der Anwesenheitsindikator und ggf. der Schaltverstärker benötigen, und zwar in der Regel so, daß der Spannungsabfall am Schaltgerät möglichst gering ist. Nun ist aber zu beachten, daß mit immer kleiner werdendem Spannungsabfall am durchgeschalteten Schaltgerät der im Lastkreis minimal zulässige Laststrom größer wird, weil ja im günstigsten Fall das Produkt aus dem Spannungsabfall am durchgeschalteten Schaltgerät und dem minimal zulässigen Laststrom im Lastkreis der für den Anwesenheitsindikator und ggf. den Schaltverstärker benötigten Hilfsleistung entsprechen muß.

Das zuvor aufgezeigte Problem ist bei einer bevorzugten Ausführungsform des erfindungsgemäßen elektronischen Schaltgerätes, der besondere Bedeutung zukommt, berücksichtigt worden. Diese Ausführungsform ist zunächst dadurch gekennzeichnet, daß die Hilfsimpedanz in Abhängigkeit vom Laststrom über den elektronischen Schalter so einstellbar ist, daß das Produkt aus dem Spannungsabfall an der Hilfsimpedanz und dem Laststrom über den elektronischen Schalter möglichst gleich oder nur geringfügig größer ist als die vom Anwesenheitsindikator und ggf. dem Schaltverstärker benötigte Leistung. Das kann einerseits dadurch realisiert sein, daß als Hilfsimpedanz eine Mehrzahl von in Reihe geschalteten Hilfsdioden vorgesehen ist und mit größer werdendem Laststrom, der über den elektronischen Schalter fließt, einzelne der die Hilfsimpedanz darstellenden Hilfsdioden kurzgeschlossen werden, - so daß, anders ausgedrückt, mit kleiner werdendem Laststrom, der über den elektronischen Schalter fließt, eine zunehmende Anzahl von In Reihe geschalteten Hilfsdioden als Hilfsimpedanz wirksam wird. Andererseits kann die zuvor angesprochene Lehre, die Hilfsimpedanz in Abhängigkeit vom Laststrom über den elektronischen Schalter einzustellen, auch dadurch realisiert sein, daß als erste Hilfsimpedanz eine Darlington-Stufe vorgesehen und in Abhängigkeit von der Wandlerspannung im Sekundärkreis des DC/DC-Wandlers gesteuert ist. Im einzelnen kann dabei die die Hilfsimpedanz darstellende Darlington-Stufe über einen Steuertransistor und der Steuertransistor von einem Komparatortransistor gesteuert sein und der Komparatortransistor von der Spannungsdifferenz zwischen einer Referenzspannung und der Wandlerspannung im Sekundärkreis des DC/DC-Wandlers oder einem Teil der Wandlerspannung im Sekundärkreis des DC/DC-Wandlers gesteuert sein.

Bei den elektronischen Schaltgeräten, von denen die Erfindung ausgeht, weist der DC/DC-Wandler ein induktives Wandlerelement, einen seinen Primärkreis im Takt einer vorgegebenen Schaltfrequenz öffnenden und schließenden Wandlerschalter und einen den Wandlerschalter mit der Schaltfrequenz steuernden Taktgenerator auf. Hier ist die eingangs beschriebene Lehre der Erfindung, den DC/DC-Wandler durch den Anwesenheitsindikator zu steuern, konkret dadurch realisierbar, daß der Taktgenerator von dem Anwesenheitsindikator - ggf. über den Schaltverstärker - steuerbar ist.

Bei den elektronischen Schaltgeräten, von denen die Erfindung ausgeht, und bei dem erfindungsgemäßen elektronischen Schaltgerät ist im Sekundärkreis des DC/DC-Wandlers ein Gleichrichter vorgesehen. Hier geht eine Lehre der Erfindung mit besonderer Bedeutung dahin, als Gleichrichter eine Leuchtdiode vorzusehen, - mit folgendem Effekt.

Bei elektronischen Schaltgeräten der in Rede stehenden Art ist häufig eine Leuchtdiode vorgesehen, mit deren Hilfe der Zustand des Schaltgerätes angezeigt werden kann, - und zwar entweder derart, daß die Leuchtdiode dann leuchtet, wenn das elektronische Schaltgerät beeinflußt ist, oder derart, daß die Leuchtdiode dann leuchtet, wenn der elektronische Schalter des elektronischen Schaltgerätes leitend ist. Einerseits benötigt die Leuchtdiode - wie der Anwesenheitsindikator und ggf. der Schaltverstärker - Hilfsleistung, deren Verbrauch in elektronischen Schaltgeräten der in Rede stehenden Art insgesamt so gering wie möglich sein soll. Andererseits kann die Leuchtdiode ihre Funktion, den Zustand des Schaltgerätes anzuzeigen, nur dann erfüllen, wenn sie einen bestimmten Lichtstrom bzw. eine bestimmte Lichtstärke hat. Da nun einerseits der Wirkungsgrad, mit dem eine Leuchtdiode elektrische Leistung in Lichtstrom und damit in Lichtstärke umsetzt, mit steigendem elektrischen Strom steigt, andererseits das menschliche Auge impulsförmiges Licht ab einer bestimmten Impulsfrequenz aufwärts als Dauerlicht empfindet, führt die Maßnahme, im Sekundärkreis des DC/DC-Wandlers als Gleichrichter eine Leuchtdiode vorzusehen, dazu, mit einer relativ geringen Hilfsleistung eine hinreichend "helle" Leuchtdiode zu bekommen.

Bisher ist immer nur gesagt worden, daß bei den in Rede stehenden elektronischen Schaltgeräten eine Hilfsschaltung zur Erzeugung einer Hilfsspannung für den Anwesenheitsindikator und ggf. den Schaltverstärker vorgesehen ist. Da aber bei den hier relevanten elektronischen Schaltgeräten der Anwesenheitsindikator - ggf. über einen Schaltverstärker - den elektronischen Schalter steuert, muß die Hilfsspannung, die mit Hilfe der Hilfsschaltung erzeugt wird, natürlich auch insgesamt in der Lage sein, den elektronischen Schalter durchzusteuern.

Nun ist es denkbar, z. B. wenn als elektronischer Schalter ein V-MOS-Transistor vorgesehen ist, daß die Hilfsspannung, die der Anwesenheitsindikator und ggf. der Schaltverstärker benötigen, eine andere ist als die, die der elektronische Schalter zum Ansteuern bzw. Durchsteuern benötigt. Folglich geht eine weitere Lehre der Erfindung dahin, einen DC/DC-Wandler vorzusehen, der - neben dem Primärkreis und dem Sekundärkreis - noch einen Tertiärkreis aufweist, und die Steuerstrecke des elektronischen Schalters in den Tertiärkreis des DC/DC-Wandlers zu legen. Dabei kann die im Tertiärkreis des DC/DC-Wandlers wirksame Wandlerspannung größer oder kleiner als die im Sekundärkreis des DC/DC-Wandlers wirksame Wandlerspannung sein.

Bei der zuletzt beschriebenen Ausführungsform des erfindungsgemäßen elektronischen Schaltgerätes, bei der der DC/DC-Wandler - neben dem Primärkreis und dem Sekundärkreis - noch einen Tertiärkreis aufweist und die Steuerstrecke des elektronischen Schalters im Tertiärkreis des DC/DC-Wandlers liegt, empfiehlt es sich, im Tertiärkreis des DC/DC-Wandlers einen Gleichrichter, z. B. eine Gleichrichterdiode, und zwischen dem Anwesenheitsindikator bzw. dem dem Anwesenheitsindikator nachgeschalteten Schaltverstärker und der Steuerelektrode des elektronischen Schalters eine Entkoppeldiode vorzusehen. Das läßt sich insgesamt auch dadurch realisieren, daß als Gleichrichter die Emitter-Basis-Strecke einen PNP-Steuertransistor und als Entkoppeldiode die Kollektor-Basis-Strecke dieses PNP-Steuertransistors verwendet ist.

Im folgenden wird die Erfindung anhand einer lediglich Ausführungsbeispiele darstellenden Zeichnung nochmals erläutert; es zeigt:

Fig. 1 stark schematisiert, das Schaltbild einer ersten Ausführungsform eines erfin-

Fig. 2 dungsgemäßen Schaltgerätes, detaillierter als in Fig. 1 dargestellt, das Schaltbild einer zweiten Ausführungsform eines erfindungsgemäßen Schaltgerätes,

Fig. 3 das Schaltbild einer dritten Ausführungsform eines erfindungsgemäßen Schaltgerätes,

Fig. 4 das Schaltbild einer vierten Ausführungsform eines erfindungsgemäßen Schaltgerätes,

Fig. 5 das Schaltbild einer fünften Ausführungsform eines erfindungsgemäßen Schaltgerätes,

Fig. 6 das Schaltbild einer sechsten Ausführungsform eines erfindungsgemäßen Schaltgerätes,

Fig. 7 das Schaltbild einer siebten Ausführungsform eines erfindungsgemäßen Schaltgerätes,

Fig. 8 das Schaltbild einer achten Ausführungsform eines erfindungsgemäßen Schaltgerätes und

Fig. 9 das Schaltbild einer neunten Ausführungsform eines erfindungsgemäßen Schaltgerätes.

Die in den Figuren dargestellten elektronischen Schaltgeräte arbeiten berührungslos und sind jeweils, was in den Figuren nicht dargestellt ist, über einen Außenleiter mit einem Pol einer Spannungsquelle und nur über einen weiteren Außenleiter mit einem Anschluß eines Verbrauchers verbindbar, wobei der andere Anschluß des Verbrauchers an den anderen Pol der Spannungsquelle anschließbar ist, der Verbraucher kann an der mit + oder der mit - gekennzeichneten Stelle angeschlossen werden.

In ihrem wesentlichen Aufbau bestehen die in den Figuren dargestellten Schaltgeräte aus einem von außen beeinflußbaren Anwesenheitsindikator 1, z. B. einem Oszillator, aus einem von dem Anwesenheitsindikator 1 über einen Schaltverstärker 2 steuerbaren elektronischen Schalter 3 und aus einer Hilfsschaltung 4 zur Erzeugung einer Hilfsspannung für den Anwesenheitsindikator 1 und den Schaltverstärker 2. Die Hilfsschaltung 4 zur Erzeugung einer Hilfsspannung für den Anwesenheitsindikator 1 und den Schaltverstärker 2 weist ein Stromzuführungselement 5, ein Spannungsbegrenzungselement 6, einen DC/DC-Wandler 7 und einen Ladekondensator 8 auf.

In den dargestellten Ausführungsbeispielen eines erfindungsgemäßen elektronischen Schaltgerätes ist das Stromzuführungselement 5 als Konstantstromgenerator bzw. mit dem Spannungsbegrenzungselement 6 als Konstantspannungsgenerator ausgeführt und liegt der Ladekondensator 8 im Sekundärkreis des DC/DC-Wandlers 7.

Erfindungsgemäß ist zunächst der DC/DC-Wandler 7 von dem Anwesenheitsindikator 1 steuerbar, - d. h. der DC/DC-Wandler 7 arbeitet dann, wenn in seinem Primärkreis ein Hilfsstrom eingespeist wird und er von dem Anwesenheitsindikator 1 - über den Schaltverstärker 2 - angesteuert ist.

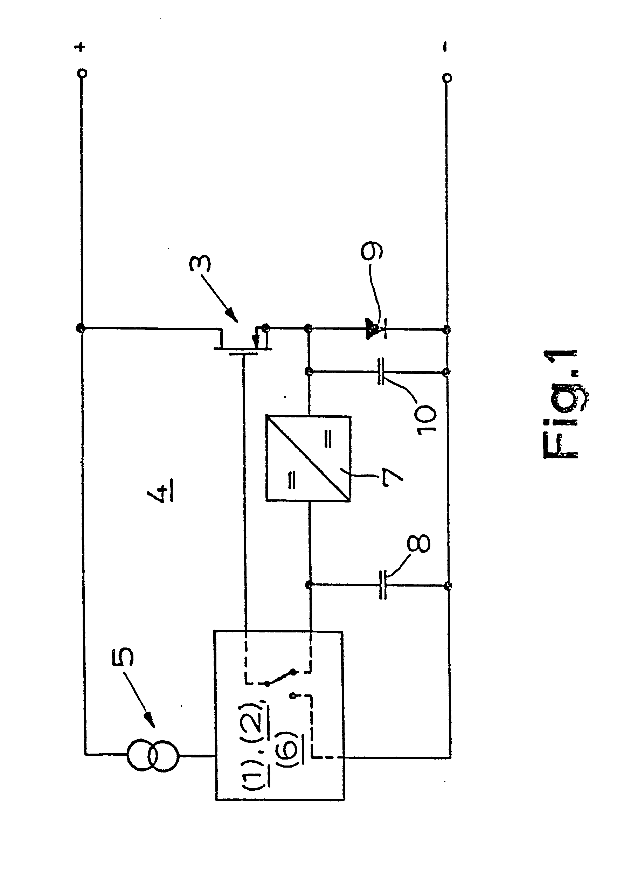

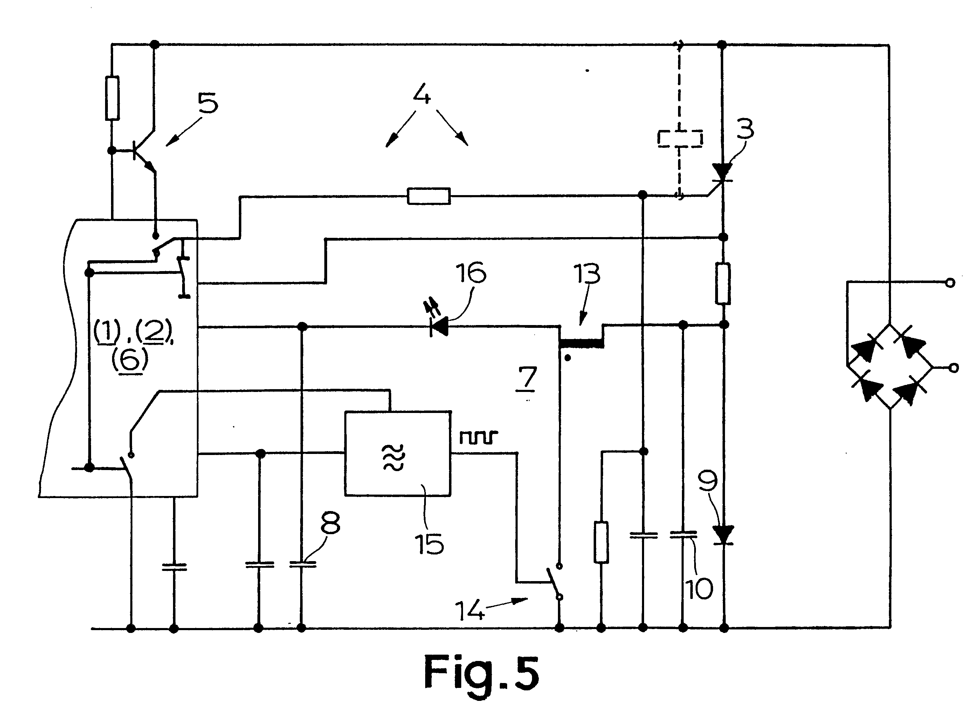

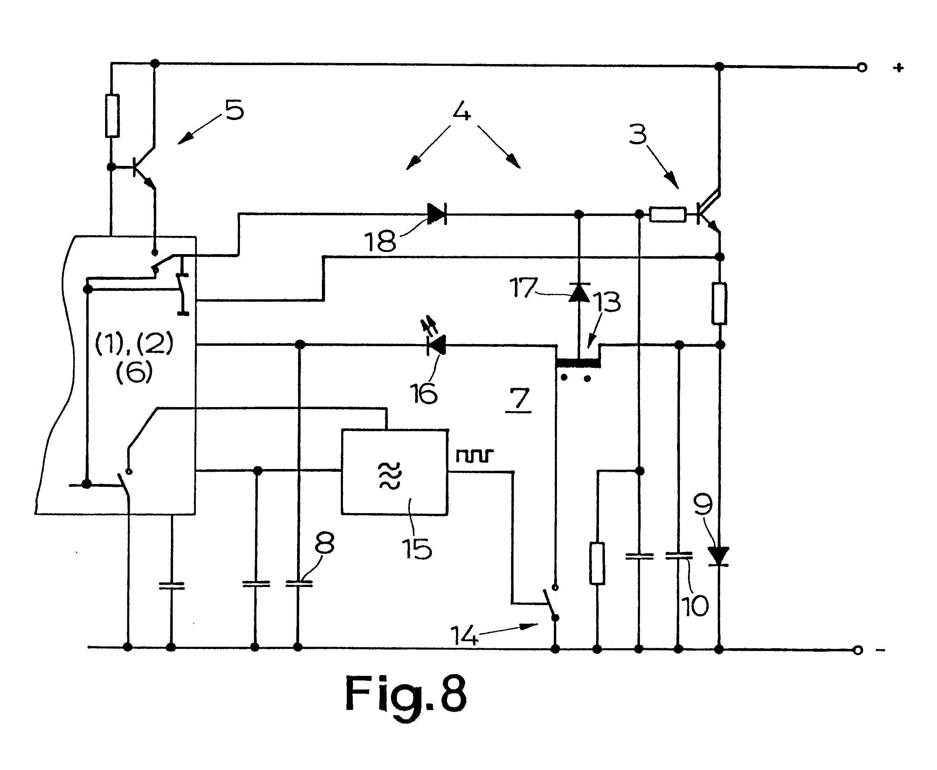

In allen in den Figuren dargestellten Ausführungsbeispielen eines erfindungsgemäßen elektronischen Schaltgerätes ist in Reihe zu dem elektronischen Schalter 3 eine Hilfsimpedanz 9, in den Ausführungsbeispielen nach den Fig. 1 bis 8 eine Hilfsdiode, geschaltet und ist der Primärkreis des DC/DC-Wandlers 7 der Hilfsimpedanz 9 parallelgeschaltet. Dabei ist der Hilfsimpedanz 9 jeweils ein Pufferkondensator 10 parallelgeschaltet.

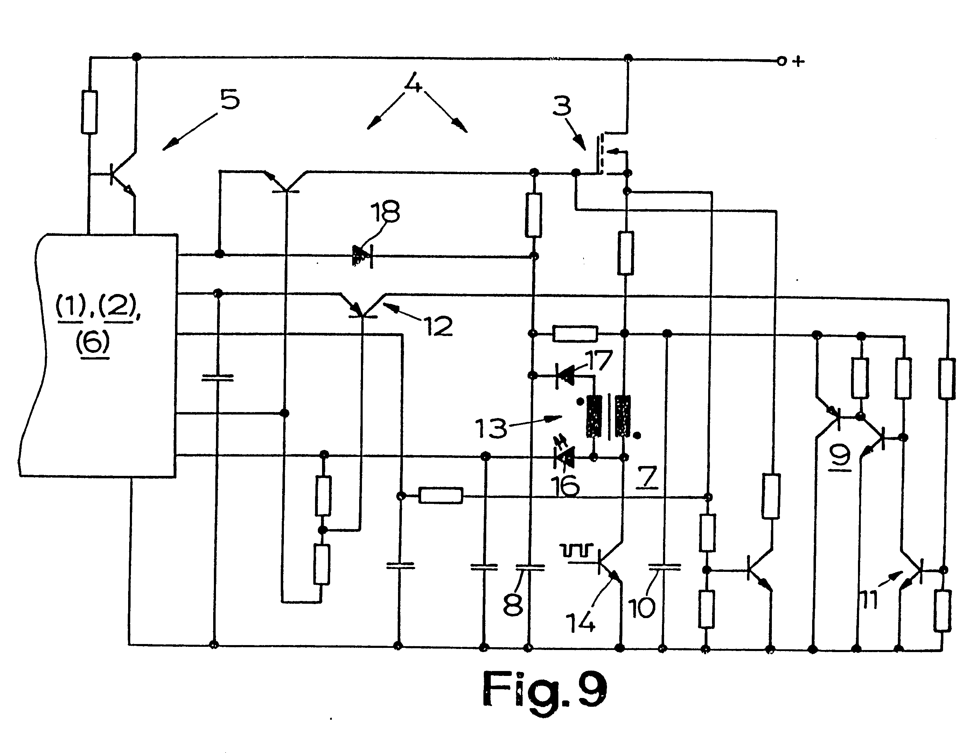

Im Ausführungsbeispiel nach Fig. 9 ist die Hilfsimpedanz 9 in Abhängigkeit vom Laststrom über den elektronischen Schalter 3 so einstellbar, daß das Produkt aus dem Spannungsabfall an der Hilfsimpedanz 9 und dem Laststrom über den elektronischen Schalter 3 möglichst gleich oder nur geringfügig größer ist als die von dem Anwesenheitsindikator 1 und dem Schaltverstärker 2 benötigte Hilfsleistung. Das ist dadurch realisiert, daß als Hilfsimpedanz 9 eine Darlington-Stufe vorgesehen und in Abhängigkeit von der Wandlerspannung im Sekundärkreis des DC/DC-Wandlers 7 gesteuert ist. Im einzelnen ist die die Hilfsimpedanz 9 darstellende Darlington-Stufe über einen Steuertransistor 11 und der Steuertransistor 11 von einem Komparatortransistor 12 gesteuert, während der Komparatortransistor 12 von der Spannungsdifferenz zwischen einer Referenzspannung und einem Teil der Wandlerspannung im Sekundärkreis des DC/DC-Wandlers 7 gesteuert ist.

Bei allen dargestellten elektronischen Schaltgeräten weist der DC/DC-Wandler 7 ein induktives Wandlerelement 13, einen seinem Primärkreis im Takt einer vorgegebenen Schaltfrequenz öffnenden und schließenden Wandlerschalter 14 und einen den Wandlerschalter 14 mit der Schaltfrequenz steuernden Taktgenerator 15 auf. Hier ist die weiter oben beschriebene Lehre der Erfindung, den DC/DC-Wandler 7 durch den Anwesenheitsindikator 1 zu steuern, konkret dadurch realisiert, daß der Taktgenerator 15 von dem Anwesenheitsindikator 1 über den Schaltverstärker 2 steuerbar ist.

Im übrigen ist in allen dargestellten Ausführungsbeispielen eines erfindungsgemäßen elektronischen Schaltgerätes im Sekundärkreis des DC/DC-Wandlers ein Gleichrichter 16 vorgesehen, und zwar in Form einer Leuchtdiode.

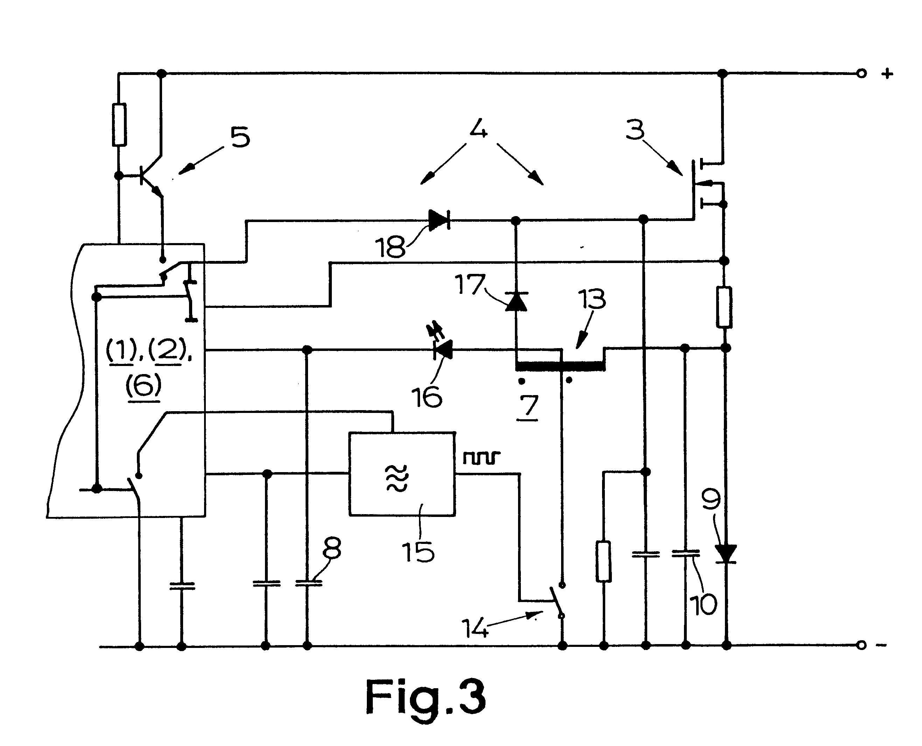

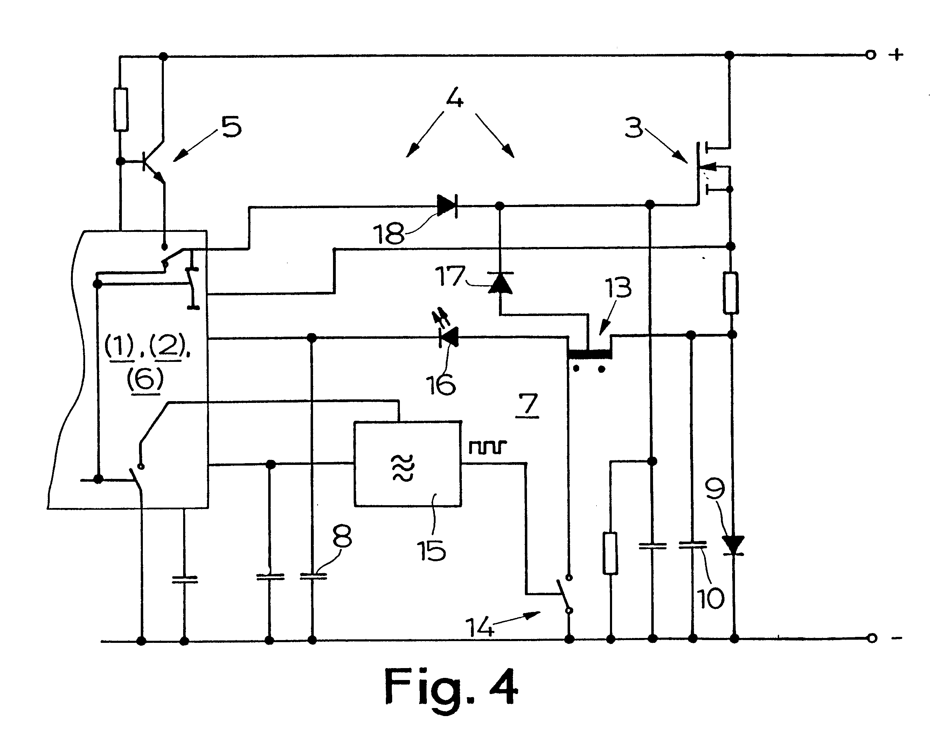

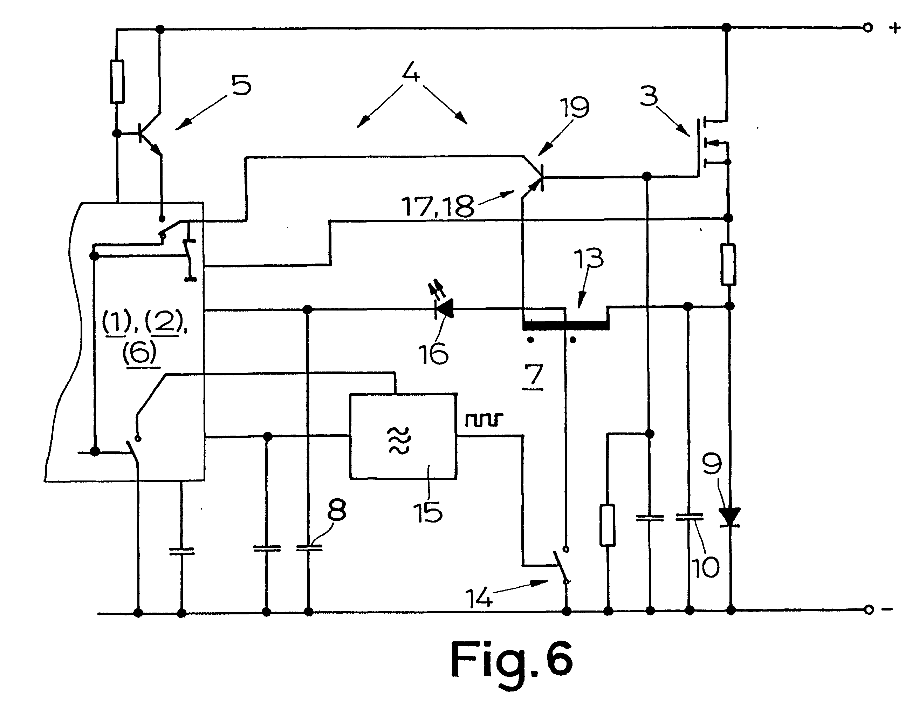

In den in den Fig. 3, 4, 6, 7 und 8 dargestellten Ausführungsbeispielen eines erfindungsgemäßen elektronischen Schaltgerätes ist die Hilfsspannung, die der Anwesenheitsindikator 1 und der Schaltverstärker 2 benötigen, eine andere als die, die der elektronische Schalter 3 zum Ansteuern bzw. Durchsteuern benötigt. Folglich weist in diesen Ausführungsbeispielen der DC/DC-Wandler - neben dem Primärkreis und dem Sekundärkreis - noch einen Tertiärkreis auf und liegt die Steuerstrecke des elektronischen Schalters 3 im Tertiärkreis des DC/DC-Wandlers 7. Dabei ist in den Ausführungsbeispielen nach den Fig. 3 und 6 die im Tertiärkreis des DC/DC-Wandlers 7 wirksame Wandlerspannung größer als die im Sekundärkreis des DC/DC-Wandlers 7 wirksame Wandlerspannung, während im Ausführungsbeispiel nach den Fig. 4, 7 und 8 die im Tertiärkreis des DC/DC-Wandlers 7 wirksame Wandlerspannung kleiner ist als die im Sekundärkreis des DC/DC-Wandlers 7 wirksame Wandlerspannung. Im Ausführungsbeispiel nach den Fig. 3 und 6 ist nämlich als elektronischer Schalter 3 ein V-MOS-Transistor vorgesehen, der eine relativ hohe Steuerspannung benötigt, während in den Ausführungsbeispielen nach den Fig. 4, 7 und 8 als elektronischer Schalter 3 ein V-MOS-Transistor vorgesehen ist, der eine relativ geringe Steuerspannung benötigt.

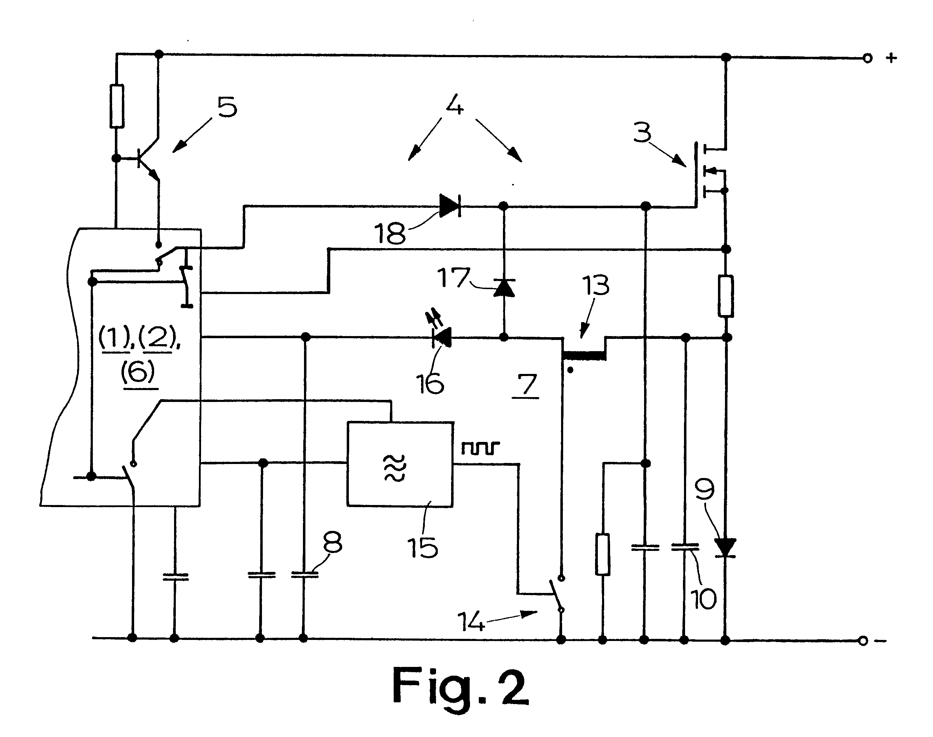

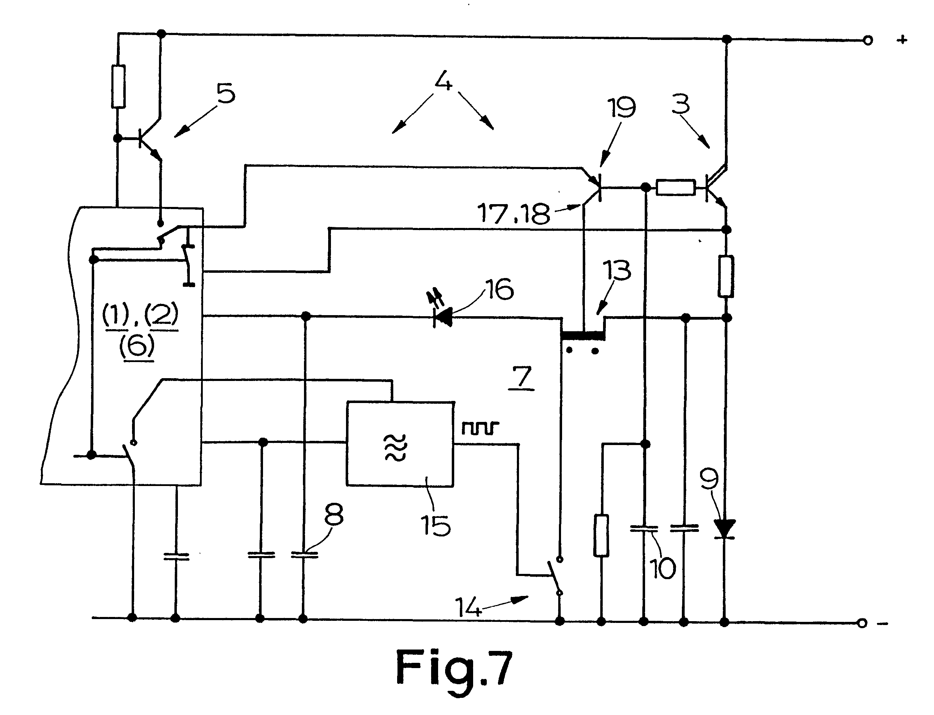

Schließlich zeigen die Fig. 2 bis 4 und 6 bis 8 insoweit bevorzugte Ausführungsformen von erfindungsgemäßen elektronischen Schaltgeräten, als im Tertiärkreis des DC/DC-Wandlers 7 ein Gleichrichter 17 und zwischen dem Anwesenheitsindikator 1 bzw. dem dem Anwesenheitsindikator 1 nachgeschalteten Schaltverstärker 2 und der Steuerelektrode des elektronischen Schalters 3 eine Entkoppeldiode 18 vorgesehen ist. In den Ausführungsbeispielen, die in den Fig. 6 und 7 dargestellt sind, ist als Gleichrichter 17 die Emitter-Basis-Strecke bzw. die Kollektor-Basis-Strecke eines PNP-Steuertransistors 19 und als Entkoppeldiode 18 die Kollektor-Basis-Strecke bzw. die Emitter-Basis-Strecke dieses PNP-Steuertransistors 19 verwendet.


**Patentansprüche**

1. Elektronisches Schaltgerät, das über einen Außenleiter mit einem Pol einer Spannungsquelle und nur über einen weiteren Außenleiter mit einem Anschluß eines Verbrauchers verbindbar ist, wobei der andere Anschluß des Verbrauchers an den anderen Pol der Spannungsquelle anschließbar ist, mit einem von außen beeinflußbaren Anwesenheitsindikator, mit einem von dem Anwesenheitsindikator - ggf. über einen Schaltverstärker - steuerbaren elektronischen Schalter und mit einer Hilfsschaltung zur Erzeugung einer Hilfsspannung für den Anwesenheitsindikator und ggf. den Schaltverstärker, wobei die Hilfsschaltung zur Erzeugung einer Hilfsspannung für den Anwesenheitsindikator und ggf. den Schaltverstärker ein Stromzuführungselement, ein Spannungsbegrenzungselement und einen DC/DC-Wandler aufweist, dadurch gekennzeichnet, daß der Primärkreis des DC/DC-Wandlers dem elektronischen Schalter oder dem Brückeneingang eines dem elektronischen Schalter ggf. vorgeschalteten Brückengleichrichters parallelgeschaltet ist und der DC/DC-Wandler unmittelbar von dem Anwesenheitsindikator - ggf. über den Schaltverstärker - gesteuert wird.

2. Elektronisches Schaltgerät, das über einen Außenleiter mit einem Pol einer Spannungsquelle und nur über einen weiteren Außenleiter mit einem Anschluß eines Verbrauchers verbindbar ist, wobei der andere Anschluß des Verbrauchers an den anderen Pol der Spannungsquelle anschließbar ist, mit einem von außen beeinflußbaren Anwesenheitsindikator, mit einem von dem Anwesenheitsindikator - ggf. über einen Schaltverstärker - steuerbaren elektronischen Schalter und mit einer Hilfsschaltung zur Erzeugung einer Hilfsspannung für den Anwesenheitsindikator und ggf. den Schaltverstärker, wobei die Hilfsschaltung zur Erzeugung einer Hilfsspannung für den Anwesenheitsindikator und ggf. den Schaltverstärker ein Stromzuführungselement, ein Spannungsbegrenzungselement und einen DC/DC-Wandler aufweist, in Reihe zu dem elektronischen Schalter eine im wesentlichen reelle Hilfsimpedanz geschaltet ist und der Primärkreis des DC/DC-Wandlers der Hilfsimpedanz parallelgeschaltet ist, dadurch gekennzeichnet, daß der Hilfsimpedanz (9) ein Pufferkondensator (10) parallelgeschaltet ist und der DC/DC-Wandler (7) unmittelbar von dem Anwesenheitsindikator (1) - ggf. über den Schaltverstärker (2) - gesteuert wird.

3. Elektronisches Schaltgerät nach Anspruch 2, dadurch gekennzeichnet, daß die Hilfsimpedanz (9) in Abhängigkeit vom Laststrom über den elektronischen Schalter (3) so einstellbar ist, daß das Produkt aus dem Spannungsabfall an der Hilfsimpedanz (9) und dem Laststrom über den elektronischen Schalter (3) möglichst gleich oder nur geringfügig größer ist als die vom Anwesenheitsindikator (1) und ggf. dem Schaltverstärker (2) benötigte Hilfsleistung.

4. Elektronisches Schaltgerät nach Anspruch 3, dadurch gekennzeichnet, daß als Hilfsimpedanz eine Mehrzahl von in Reihe geschalteten Hilfsdioden vorgesehen ist und mit größer werdendem Laststrom, der über den elektronischen Schalter fließt, einzelne der die Hilfsimpedanz darstellenden Hilfsdioden kurzgeschlossen werden.

5. Elektronisches Schaltgerät nach Anspruch 3, dadurch gekennzeichnet, daß als Hilfsimpedanz (9) eine Darlington-Stufe vorgesehen und in Abhängigkeit von der Wandlerspannung im Sekundärkreis des DC/DC-Wandlers (7) gesteuert ist.

6. Elektronisches Schaltgerät nach Anspruch 5, dadurch gekennzeichnet, daß die die Hilfsimpedanz (9) darstellende Darlington-Stufe über einen Steuertransistor (11) und der Steuertransistor (11) von einem Komparatortransistor (12) gesteuert ist und der Komparatortransistor (12) von der Spannungsdifferenz zwischen einer Referenzspannung und der Wandlerspannung im Sekundärkreis des DC/DC-Wandlers (7) oder einem Teil der Wandlerspannung im Sekundärkreis des DC/DC-Wandlers (7) gesteuert ist.

7. Elektronisches Schaltgerät nach einem der Ansprüche 1 bis 6, wobei der DC/DC-Wandler ein induktives Wandlerelement, einen seinen Primärkreis im Takt einer vorgegebenen Schaltfrequenz öffnenden und schließenden Wandlerschalter und einen den Wandlerschalter mit der Schaltfrequenz steuernden Taktgenerator aufweist, dadurch gekennzeichnet, daß der Taktgenerator (15) von dem Anwesenheitsindikator (1) - ggf. über den Schaltverstärker (2) - steuerbar ist.

8. Elektronisches Schaltgerät nach einem der Ansprüche 1 bis 7, wobei im Sekundärkreis des DC/DC-Wandlers ein Gleichrichter vorgesehen ist, dadurch gekennzeichnet, daß als Gleichrichter (16) eine Leuchtdiode vorgesehen ist.

9. Elektronisches Schaltgerät nach einem der Ansprüche 1 bis 8, wobei z. B. als elektronischer Schalter ein V-MOS-Transistor vorgesehen ist, dadurch gekennzeichnet, daß der DC/DC-Wandler (7) - neben dem Primärkreis und dem Sekundärkreis - noch einen Tertiärkreis aufweist und die Steuerstrecke des elektronischen Schalters (3) im Tertiärkreis des DC/DC-Wandlers (7) liegt.

10. Elektronisches Schaltgerät nach Anspruch 9, dadurch gekennzeichnet, daß die im Tertiärkreis des DC/DC-Wandlers (7) wirksame Wandlerspannung größer oder kleiner ist als die im Sekundärkreis des DC/DC-Wandlers (7) wirksame Wandlerspannung.

**Claims**

1. Electronic switching equipment that is permanently connectable by an external lead to one pole of a voltage source and is permanently connectable by only one further external lead to one terminal of a load, the other terminal of the load being connectable to the other pole of the voltage source, with a presence indicator that is influencable from the outside, with an electronic switch controllable from the presence indicator, via a switching amplifier if required, and with an auxiliary circuit for the generation of an auxiliary voltage for the presence indicator, and if required for the switching amplifier, in which the auxiliary circuit for the production of an auxiliary voltage for the presence indicator, and if required for the switching amplifier, possesses a current supply unit a voltage-limiting unit and a DC/DC convertor, characterized in that the primary circuit of the DC/DC converter is connected in parallel to the electronic switch or to the bridge input of a bridge rectifier that if required is connected in series with the electronic switch, and the DC/DC converter is directly controlled by the presence indicator, via the switching amplifier if required.

2. Electronic switching equipment that is permanently connectable by an external lead to one pole of a voltage source and is permanently connectable by only one further external lead to one terminal of a load, the other terminal of the load being connectable to the other pole of the voltage source, with a presence indicator that is influenceable from the outside, with an electronic switch controllable from the presence indicator, via a switching amplifier if required, and with an auxiliary circuit for the generation of an auxiliary voltage for the presence indicator, and if required for the switching amplifier, in which the auxiliary circuit for the production of an auxiliary voltage for the presence indicator, and if required for the switching amplifier, possesses a current supply unit a voltage-limiting unit and a DC/DC convertor, an essentially real auxiliary the primary circuit of the DC/DC convertor is connected in parallel to the auxiliary impedance, characterized in that a surge capacitor (10) is connected in parallel to the auxiliary impedance (9) and the DC/DC convertor (7) is controlled directly from the presence indicator (7) - via the switching amplifier (2) if required.

3. Electronic switching equipment according to Claim 2, chracterized in that the auxiliary impedance (9) is so adjustable in accordance with the load current through the electronic switch (3), that the product of the voltage drop across the auxiliary impedance (9) and the load current through the electronic switch (3) is as nearly as possible equal to or only slightly greater than the auxiliary power required by the presence indicator (1) and the switching amplifier (2) if present.

4. Electronic switching equipment according to Claim 3, characterized in that a plurality of auxiliary diodes connected in series is provided as auxiliary impedance, and as the load current that flows through the electronic switch becomes greater individual auxiliary diodes that make up the auxiliary impedance are short-circuited.

5. Electronic switching equipment according to Claim 3, characterizes in that a Darlington stage is provided as auxiliary impedance (9) and is controlled in accordance with the convertor voltage in the secondary circuit of the DC/DC convertor (7).

6. Electronic swithing equipment according to Claim 5, characterized in that the Darlington stage that represents the auxiliary impedance (9) is controlled via a control transistor (11) and the control transistor (11) is controlled by a comparator transistor (12), and the comparator transistor (12) is controlled by the voltage difference between a reference voltage and the convertor voltage in the secondary circuit of the DC/DC convertor (7) or a portion of the convertor voltage in the secondary circuit of the DC/DC convertor (7).

7. Electronic switching equipment according to one of Claims 1 to 6, in which the DC/DC convertor possesses an inductive convertor unit, a convertor switch opening and closing its primary circuit in time with a specified switching frequency and a timing generator controlling the convertor switch at the switching frequency, characterized in that the timing generator (15) is controllable by the presence indicator (1) - via switching amplifier (2) if present.

8. Electronic switching equipment according to one of Claims 1 to 7, in which a rectifier is provided in the secondary circuit of the DC/DC

convertor, <u>characterizing in that</u> a light diode is provided as rectifier (16).

9. Electronic switching equipment according to one of Claims 1 to 8 in which e.g. a V-MOS transistor is provided as electronic switch, <u>characterized in that</u> the DC/DC convertor (7) possesses a tertiary circuit in addition to the primary circuit and the secondary circuit, and the control path of the electronic switch (3) is part of the tertiary circuit of DC/DC convertor (7).

10. Electronic switching equipment according to Claim 9, <u>characterized in that</u> the convertor voltage effective in the tertiary circuit of DC/DC convertor (7) is greater or less than the convertor voltage effective in the secondary circuit of the DC/DC convertor (7).

## Revendications

1. Appareil de commutation électronique qui peut être connecté par l'intermédiaire d'un conducteur extérieur sur un pôle d'une source de tension et seulement par l'intermédiaire d'un autre conducteur extérieur sur un branchement d'un consommateur de courant, l'autre branchement du consommateur de courant pouvant être relié à l'autre pôle de la source de tension, avec un indicateur de présence pouvant être influencé par l'extérieur, avec un commutateur électronique commandable - le cas échéant par l'intermédiaire d'un amplificateur de couplage - et avec un circuit auxiliaire pour la production d'une tension auxiliaire pour l'indicateur de présence et éventuellement l'amplificateur de couplage, le circuit de couplage pour la production d'une tension auxiliaire pour l'indicateur de présence et éventuellement l'amplificateur de couplage comprenant un élément d'amenée de courant, un élément de limitation de tension et un convertisseur à courant continu, <u>caractérisé par le fait</u> que le circuit primaire du convertisseur à courant continu est monté en parallèle avec le commutateur électronique ou avec l'entrée du pont d'un redresseur à pont éventuellement monté en amont du commutateur électronique et que le convertisseur à courant continu est commandé directement par l'indicateur de présence, éventuellement par l'intermédiaire de l'amplificateur de couplage.

2. Appareil de commutation électronique qui peut être connecté par l'intermédiaire d'un conducteur extérieur sur un pôle d'une source de tension et seulement par l'intermédiaire d'un autre conducteur extérieur sur un branchement d'un consommateur de courant, l'autre branchement du consommateur de courant pouvant être relié à l'autre pôle de la source de tension, avec un indicateur de présence pouvant être influencé par l'extérieur, avec un commutateur électronique commandable - le cas échéant par l'intermédiaire d'un amplificateur de couplage - et avec un circuit auxiliaire pour la production d'une tension auxiliaire pour l'indicateur de présence et éventuellement l'amplificateur de couplage, le circuit de couplage pour la production d'une tension auxiliaire pour l'indicateur de présence et éventuellement l'amplificateur de couplage comprenant un élément d'amenée de courant, un élément de limitation de tension et un convertisseur à courant continu, une impédance auxiliaire sensiblement réelle étant montée en série avec le commutateur électronique et le circuit primaire du convertisseur à courant continu étant monté en parallèle avec l'impédance auxiliaire, <u>caractérisé par le fait</u> qu'un condensateur tampon (10) est monté en parallèle avec l'impédance auxiliaire (9) et que le convertisseur à courant continu (7) est commandé directement par l'indicateur de présence (1), éventuellement par l'intermédiaire de l'amplificateur de couplage (2).

3. Appareil de commutation électronique selon la revendication 2, caractérisé par le fait que l'impédance auxiliaire (9) peut être réglée en fonction du courant 4e charge passant par le commutateur électronique (3) de telle façon que le produit de la chute de tension sur l'impédance auxiliaire (9) par le courant de charge passant par le commutateur électronique (3) est autant que possible égal ou seulement légèrement supérieur à la puissance auxiliaire nécessaire pour l'indicateur de présence (1) et éventuellement l'amplificateur de couplage (2).

4. Appareil de commutation électronique selon la revendication 3, caractérisé par le fait qu'il est prévu comme impédance auxiliaire une pluralité de diodes auxiliaires montées en série et que, au fur et à mesure de l'augmentation du courant de charge qui passe par le commutateur électronique, certaines des diodes auxiliaires représentant l'impédance auxiliaire sont court-circuitées.

5. Appareil de commutation électronique selon la revendication 3, caractérisé par le fait qu'un étage de Darlington est prévu comme impédance auxiliaire (9) et commandé en fonction de la tension de convertisseur dans le circuit secondaire du convertisseur à courant continu (7).

6. Appareil de commutation électronique selon la revendication 5, caractérisé par le fait que l'étage de Darlington représentant l'impédance auxiliaire (9) est commandé par l'intermédiaire d'un transistor de commande (11), lequel transistor de commande (11) est commandé par un transistor comparateur (12) et que ledit transistor comparateur (12) est commandé par la différence de tension entre une tension de référence et la tension de convertisseur dans le circuit secondaire du convertisseur à courant continu (7) ou une partie de la tension de convertisseur dans le circuit secondaire du convertisseur à courant continu (7).

7. Appareil de commutation électronique selon l'une quelconque des revendications 1 à 6, le convertisseur à courant continu comportant un élément convertisseur inductif, un commutateur de convertisseur ouvrant et fermant son circuit primaire au rythme d'une fréquence de commutation prédéterminée et un générateur d'impulsions qui commande le commutateur de convertisseur à la fréquence de commutation, caractérisé par le fait que le générateur d'impulsions (15) peut être commandé par l'indicateur de présence (1), éventuellement par l'intermédiaire de l'amplificateur de couplage (2).

8. Appareil de commutation électronique selon l'une quelconque des revendications 1 à 7, un redresseur étant prévu dans le circuit secondaire du convertisseur à courant continu, caractérisé par le fait qu'une diode électroluminescente est prévue comme redresseur (16).

9. Appareil de commutation électronique selon l'une quelconque des revendications 1 à 8, un transistor V-MOS étant prévu, par exemple, comme commutateur électronique, caractérisé par le fait que le convertisseur à courant continu (7) comporte encore - en plus du circuit primaire et du circuit secondaire - un circuit tertiaire et que la voie de commande du commutateur électronique (3) est placée dans le circuit tertiaire du convertisseur à courant continu (7).

10. Appareil de commutation électronique selon la revendication 9, caractérisé par le fait que la tension de convertisseur efficace dans le circuit tertiaire du convertisseur à courant continu (7) est supérieure ou inférieure à la tension de convertisseur dans le circuit secondaire du convertisseur à courant continu (7).

Fig.1

Fig. 2

Fig.3

EP 0 131 146 B1

Fig. 4

EP 0 131 146 B1

**Fig.5**

EP 0 131 146 B1

Fig.6

(1), (2),
(6)

Fig.7

Fig.8

Fig.9

EP 0 131 146 B1